# EUROPÄISCHE PATENTSCHRIFT

(11) **EP 2 753 727 B1**
(45) Veröffentlichungstag und Bekanntmachung des Hinweises auf die Patenterteilung: **12.01.2022**
(21) Anmeldenummer: 12759013.1
(22) Anmeldetag: 29.08.2012
(51) Int. Cl.: C23C 14/00, C23C 14/02, C23C 14/06, B60R 13/04, C23C 28/00

(54) **ZIERTEIL FÜR KRAFTFAHRZEUGE**
DECORATIVE PART FOR MOTOR VEHICLES
PIÈCE DÉCORATIVE POUR VÉHICULES AUTOMOBILES

(30) Priorität: 05.09.2011 DE 102011112288
(43) Veröffentlichungstag der Anmeldung: 16.07.2014
(73) Patentinhaber: Oerlikon Surface Solutions AG, Pfäffikon, 8808 Pfäffikon (CH)
(72) Erfinder: RIBEIRO, Carlos, Hochiminh City Saigon (VN); BAUER, Sascha, 88605 Meßkirch (DE)
(74) Vertreter: Kempkens, Anke
(86) Internationale Anmeldenummer: PCT/EP2012/003624
(87) Internationale Veröffentlichungsnummer: WO 2013/034259

(56) Entgegenhaltungen:
- WO-A1-03/053686
- WO-A1-2004/084690
- WO-A2-2005/118282
- DE-A1-102005 053 344
- US-A1- 2008 014 420

## Beschreibung

Es besteht daher ein Bedürfnis danach die oben aufgeführten Nachteile des Stand der Technik zu überwinden oder zumindest abzuschwächen.

Erfindungsgemäss wird vorgeschlagen, auf der Galvanikschichtanordnung ein PVD-Schichtsystem vorzusehen, welches eine direkt auf der Galvanikschichtanordnung aufliegende Haftschicht, eine auf der Haftschicht aufgebrachte beständige und harte Mischschicht und eine auf der Mischschicht aufgebrachte farbgebende Deckschicht umfasst. Die farbgebende Deckschicht muss dabei nicht die Härte- und Beständigkeitsanforderungen der Mischschicht erfüllen.

Die mittels PVD aufgebrachte Haftschicht umfasst ein Material, welches gut auf der Oberfläche der Galvanikschicht haftet. Vorzugsweise ist dieses Material dem Oberflächenmaterial der Galvanikschichtanordnung sehr ähnlich, besonders bevorzugt sogar mit diesem im Wesentlichen identisch. Besteht beispielsweise die die Galvanikschichtanordnung abschliessende Schicht aus Chrom, so kann als Haftschicht eine mittels PVD aufgebrachte Chromschicht verwendet werden. Ist demgegenüber die die Galvanikschichtanordnung abschliessende Schicht eine Chrom-Nickelschicht oder eine Schicht mit hohem Nickelanteil so wird der Einsatz von Zirkon als Haftschicht von Vorteil sein falls keine dem Nickel entsprechende PVD-Schicht abgeschieden werden kann. Erfindungsgemäss ist die Haftschicht 0.1 µm bis 1µm dick.

Auf die Haftschicht wird nun erfindungsgemäss mittels PVD eine Mischschicht des Typs (Me1ₐMe2_{b})ᵤXᵥ aufgebracht, wobei Me1 ein erstes Metall und Me2 ein zweites, sich vom ersten Metall unterscheidendes Metall ist und für die Parameter a und b gilt: a>0.05 und b>0.05 und a+b=1, d.h. Me1 und Me2 bilden 100% der metallischen Elemente in der Mischschicht und wobei X ein oder mehrere Elemente aus der Gruppe gebildet durch Kohlenstoff, Stickstoff und Sauerstoff ist, wobei X sowohl Stickstoff als auch Kohlenstoff umfasst, und wobei Me1 Chrom und Me2 Zirkon ist.

Die Komponente X ist in der Mischschicht höchstens in stöchiometrischer Konzentration vorhanden, wobei zumindest in der Nähe der Haftschicht eine unterstöchiometrische Die Dokumente US 2008/0014420 A1, WO 03/053686 A1 und WO 2005/118282 A2 beschreiben jeweils beschichtete Gegenstände mit Beschichtungen mit farbgebenden Deckschichten gemäss dem Stand der Technik.

Es besteht daher ein Bedürfnis danach die oben aufgeführten Nachteile des Stand der Technik zu überwinden oder zumindest abzuschwächen.

Erfindungsgemäss wird vorgeschlagen, auf der Galvanikschichtanordnung ein PVD-Schichtsystem vorzusehen, welches eine direkt auf der Galvanikschichtanordnung aufliegende Haftschicht, eine auf der Haftschicht aufgebrachte beständige und harte Mischschicht und eine auf der Mischschicht aufgebrachte farbgebende Deckschicht umfasst. Die farbgebende Deckschicht muss dabei nicht die Härte- und Beständigkeitsanforderungen der Mischschicht erfüllen.

Die mittels PVD aufgebrachte Haftschicht umfasst ein Material, welches gut auf der Oberfläche der Galvanikschicht haftet. Vorzugsweise ist dieses Material dem Oberflächenmaterial der Galvanikschichtanordnung sehr ähnlich, besonders bevorzugt sogar mit diesem im Wesentlichen identisch. Besteht beispielsweise die die Galvanikschichtanordnung abschliessende Schicht aus Chrom, so kann als Haftschicht eine mittels PVD aufgebrachte Chromschicht verwendet werden. Ist demgegenüber die die Galvanikschichtanordnung abschliessende Schicht eine Chrom-Nickelschicht oder eine Schicht mit hohem Nickelanteil so wird der Einsatz von Zirkon als Haftschicht von Vorteil sein falls keine dem Nickel entsprechende PVD-Schicht abgeschieden werden kann. Erfindungsgemäss ist die Haftschicht 0.1 µm bis 1µm dick.

Auf die Haftschicht wird nun erfindungsgemäss mittels PVD eine Mischschicht des Typs (Me1ₐMe2_{b})ᵤXᵥ aufgebracht, wobei Me1 ein erstes Metall und Me2 ein zweites, sich vom ersten Metall unterscheidendes Metall ist und für die Parameter a und b gilt: a>0.05 und b>0.05 und a+b≤1, wobei a+b=1 bedeuten würde dass Me1 und Me2 100% der metallischen Elemente in der Mischschicht bilden und wobei X ein oder mehrere Elemente aus der Gruppe gebildet durch Kohlenstoff, Stickstoff und Sauerstoff ist. Die Mischschicht kann noch weitere Elemente und insbesondere weitere Metalle enthalten. Vorzugsweise liegen aber nichtmetallische Beimischungen von Elementen welche nicht der Gruppe X angehören in der Summe unterhalb 20at%.

Die Komponente X ist in der Mischschicht höchstens in stöchiometrischer Konzentration vorhanden, wobei zumindest in der Nähe der Haftschicht eine unterstöchiometrische Konzentration von Vorteil sein kann, da hierdurch der metallische Charakter der Schicht nicht ganz verloren geht. Dies ist aus dem Grund vorteilhaft, weil diese Schicht nicht nur hart und beständig - vor allem gegenüber Korrosion - sein soll, sondern auch als sogenannte Ausgleichsschicht für einen Abbau von Schichtspannungen sorgen soll.

Die Mischschicht kann aus in der Konzentration variierenden Nanolagen aufgebaut sein. Dies kann insbesondere dann der Fall sein, wenn im Rahmen des zur Herstellung der Mischschicht verwendeten Verfahrens die zu beschichtenden Komponenten an zwei oder mehreren Targets beispielsweise auf einem Rotationstische mehrmals vorbeigeführt werden. Eine solche Nanolagenbeschichtung kann vorteilhaft zu weiterer Entspannung und damit zu einer höheren Beständigkeit des PVD-Schichtsystems führen. Die angegebene Konzentration versteht sich daher als eine Mittelung von über mindestens 20nm. Die Mischschicht ist zwischen 0.2µm und 10µm dick und hat vorzugsweise eine Dicke unterhalb 1µm und besonders bevorzugt eine Dicke zwischen 250nm und 350nm.

Es hat sich gezeigt, dass die Verwendung einer Mischschicht, welche Chrom als Me1 und Zirkon als Me2 enthält besonders geeignet ist. Es hat sich ausserdem gezeigt, dass Mischschichten, welche sowohl Stickstoff als auch Kohlenstoff enthalten besonders geeignet sind. Damit hat eine **(CrₐZr_{b})ᵤ(CₖNₗ)ᵥ** mit a+b=1 und k+l=1 mit a,b>0 und k,l>0 welche die nichtmetallischen Bestandteile nicht überstöchiometrisch umfasst als besonders geeignet und bevorzugt für die erfindungsgemässe Mischschicht einzustufen.

Die Mischschicht kann auch einen Konzentrationsverlauf aufweisen und insbesondere eine Gradientenschicht sein. Vorteilhaft ist insbesondere ein stark metallischer Charakter in der Nähe der Haftschicht und ein gradueller Verlauf hin zu einer Schicht mit überstöchiometrischem X-Anteil.

Auf die Mischschicht wird dann eine farbgebende Deckschicht mittels abgelegt. Diese ist zwischen 0.1 µm und 2µm dick. Die Dickenbegrenzung nach unten muss eingehalten werden um den gewünschten Farbeindruck sicher zu stellen. Die Dickenbegrenzung nach oben ist vor allem dann wichtig, wenn die farbgebende Deckschicht selbst nicht die für das Zierteil notwendige Härte und Korrosionsbeständigkeit aufweist. Im einfachsten Fall kann Chrom als farbgebende Deckschicht verwendet werden, nämlich dann, wenn dem Zierteil ein verchromtes Aussehen verliehen werden soll. In diesem Fall kann der Übergang von der Mischschicht zur Deckschicht als diskontinuierlicher Übergang ausgebildet sein. Es kann aber auch ein gradueller Übergang von der Mischschicht zur Deckschicht realisiert sein. Beispielsweise kann der Chromanteil an den Metallischen Elementen in der Mischschicht mit zunehmendem Abstand vom Dickenmittelpunkt zur Deckschicht hin auf 100% zunehmen und der X-Anteil auf 0% abnehmen.

Soll dem Zierteil demgegenüber ein Aussehen gegeben werden als handle es sich um Edelstahl, so kann einerseits als Deckschicht beispielsweise V2A-Stahl mittels Zerstäuben (sputtern) aufgebracht werden oder es wird Zr-Cr-X vorgesehen, wobei der X-Anteil überstöchiometrisch gewählt sein kann.

Es wird darauf hingewiesen, dass Haftschicht und/oder Mischschicht und/oder Deckschicht jeweils aus mehreren sich unterscheidenden Schichtlagen aufgebaut sein kann. Insbesondere im Fall der farbgebenden Deckschicht können hierdurch, beispielsweise mittels Interferenz, unterschiedliche Farbeffekte erzielt werden.

Die Erfindung wird nun im Detail anhand eines Beispiels und mit Hilfe der Figuren erläutert.
Figur 1 zeigt schematisch eine Beschichtungsanlage wie sie zur PVD-Beschichtung verwendet werden kann.
Figur 2 zeigt den schematischen Schichtaufbau eines Teiles eines erfindungsgemässen Zierteiles gemäss einer Ausführungsform der vorliegenden Erfindung.

Um die Erfindung näher zu erläutern wird beispielhaft die Beschichtung zu einer erfindungsgemässen Zierleiste, welche einen sogenannten Chromlook aufweisen soll, beschrieben.

Dabei wird davon ausgegangen, dass dem Fachmann die Herstellung des Substrates bekannt ist. Es wird auch davon ausgegangen, dass dem Fachmann bekannt ist, wie er die Galvanikschichtanordnung auf dem Substrat realisieren kann. Sollten sich diesbezüglich Fragen ergeben so wird auf die oben bereits erwähnte DE 102005053344 verwiesen.

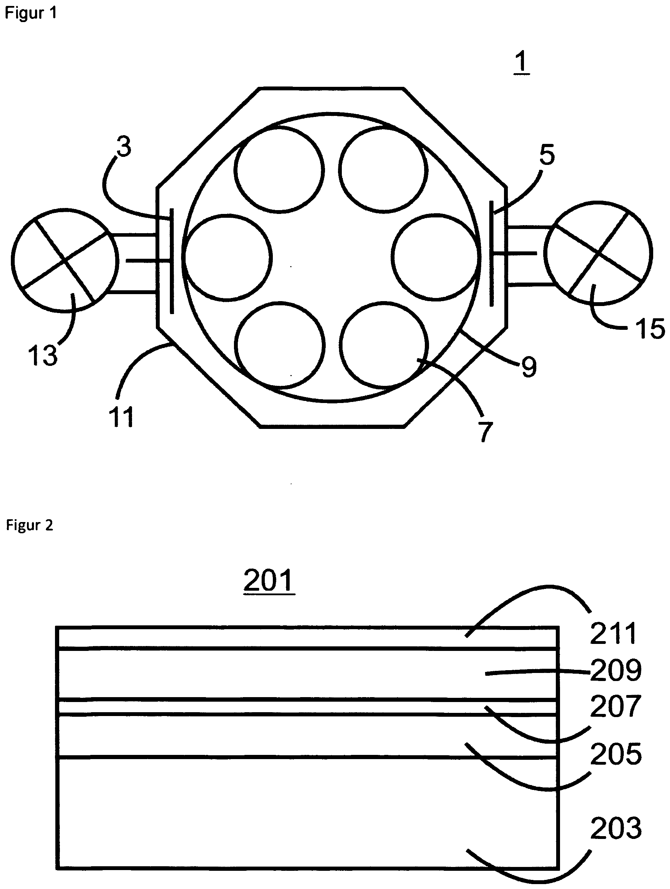

Ein derart mit einer Galvanikschichtanordnung beschichtetes Substrat wird dann in einer Beschichtungsanlage 1 wie in Figur 1 gezeigt hineingegeben. Die Beschichtungsanlage 1 umfasst ein erstes Margnetron-Sputtertarget 3 und ein zweites Magnetron-Sputtertarget 5. Das erste Magnetron-Sputtertarget 3 enthält Chrom als Sputtermaterial und ist somit ein Chrom-Target. Das zweite Magnetron-Sputtertarget 5 enthält Zirkon als Sputtermaterial und ist somit ein Zirkon-Target. Ein zu beschichtendes Substrat wird in einem Substrathalter 7 auf einen Drehteller 9 platziert, wobei der Substrathalter 7 noch um die eigene Achse rotierbar ist. Mittels des Drehtellers 9 kann das Substrat abwechselnd am ersten und am zweiten Magnetron-Sputtertarget 3,5 vorbei geführt werden. In der Figur 1 sind sechs Substrathalter gezeigt.

Nachdem die Beschichtungsanlage 1 mit den Substraten beladen ist, wird die Beschichtungskammer 11 geschlossen und es wird mittels Vakuumpumpen 13, 15 ein Vakuum in der Anlage aufgebaut. Anschliessend lässt man Argon in die Beschichtungskammer einströmen und ein Plasma wird gezündet. Es wird ein negativer Bias an die Substrate angelegt. Ionisiertes Argon wird zunächst dazu verwendet, die Oberfläche der Galvanikschichtanordnung auf dem zu beschichtenden Substrat zu reinigen, eventuell zu aktivieren und auch zu erwärmen. Allerdings sollte die Substrattemperatur unter 120°C, vorzugsweise unter 100°C gehalten werden, insbesondere dann, wenn es sich - wie vorliegend - um Kunststoffsubstrate handelt.

Nach dem Reinigungsschritt wird zunächst Leistung an das Chrom-Target 3 angelegt. Im Beispiel fliessen demzufolge 24A. Parallel dazu wird der negative Substratbias auf 65V eingestellt. Es wird für ca. 90 Sekunden reines Chrom zerstäubt, welches sich auf den Substraten ablagert. Der Substratbias trägt dazu bei, dass mittels lonenbombardement die Chromschicht verdichtet wird und damit auch besser auf dem Substrat haftet. Auf diese Weise wird die Haftschicht abgeschieden.

Anschliessend wird im Wesentlichen gleichzeitig die Leistung am Chrom-Target 3 bis auf einen Strom von 32A erhöht, Leistung an das Zirkon-Target 5 angelegt, so dass 24A fliessen und man lässt Stickstoff mit 100sccm und - leicht zeitlich versetzt - Acetylen (C₂H₂) 35sccm in die Beschichtungskammer 11 einströmen. Der Gaszustrom wird dabei auf Werte begrenzt, die gewährleisten, dass die entstehende Schicht nicht überstöchiometrisch die Bestandteile dieses Gases enthält. Die negative Biasspannung wird auf 45V abgesenkt, was zur Folge hat, dass weniger Schichtspannungen in die hiermit aufgebaute Schicht eingebaut werden. Auf diese Weise wird die erfindungsgemässe Mischschicht abgeschieden, die in diesem Fall eine Cr-Zr-C-N Schicht ist.

Anschliessend wird die Leistung am Zirkon-Target 5 abgeschaltet und der Zufluss von Stickstoff und Acetylen unterbunden, so dass lediglich noch Argon in die Kammer strömt und am Chrom-Target Leistung anliegt, welche zu einem Stromfluss von 38A führt. Auf diese Weise wird für 120 Sekunden eine farbgebende Deckschicht erzeugt, welche dem Zierteil den gewünschten Chromlook gibt. Die vorliegend angegebenen Parameter sind auf die entsprechende Beschichtungsanlage zugeschnitten. Sie variieren zwar von Anlage zu Anlage. Der Fachmann weiss allerdings, wie er die Parameter an die ihm zur Verfügung stehende Beschichtungsanlage anzupassen hat, um das gewünschte Ergebnis zu erzielen.

In Figur 2 ist schematisch der dieser Ausführungsform der vorliegenden Erfindung entsprechende Schichtaufbau eines Ausschnittes 201 eines Zierteils dargestellt. Auf einem Substrat 203 ist eine Galvanikschichtanordnung 205 aufgebracht. Auf dieser Galvanikschichtanordnung ist, in dieser Reihenfolge, eine Haftschicht 207, eine Mischschicht 209 und eine farbgebende Deckschicht 211 aufgebracht.

Sollen anstatt dem Chromlook Messing- oder Gelbtöne erzielt werden, so eignet sich ZrN als Deckschicht. Möchte man eine grüne oder braune Oberfläche erreichen, so gelingt dies mit Zr-C-N als Deckschicht mit jeweils angepasstem Kohlenstoff- und Stickstoffanteil. Soll der Oberfläche das Aussehen von Edelstahl gegeben werden, so lässt sich V2A als Deckschicht zerstäuben. Grautöne lassen sich mittels Cr-Zr-C-N erreichen wobei C und/oder N überstöchiometrisch in der Deckschicht vorhanden sind.

## Patentansprüche

1. Zierteil für ein Kraftfahrzeug, umfassend:
- ein Substrat, vorzugsweise ein Kunststoffsubstrat
- eine Galvanikschichtanordnung auf dem Substrat
- eine durch physikalische Gasphasenabscheidung auf der äusseren Oberfläche der Galvanikschichtanordnung aufgebrachte farbgebende Deckschicht **dadurch gekennzeichnet, dass**
die farbgebende Deckschicht Teil eines PVD-Schichtsystems ist welche zwischen Substrat und Deckschicht eine Haftschicht und zwischen Haftschicht und Deckschicht eine Mischschicht umfasst, wobei die Mischschicht ein erstes Metall Me1 und ein zweites Metall Me2 umfasst und in der Mischschicht Elemente X beinhaltet, wobei X ein oder mehrere Elemente der Gruppe gebildet aus Stickstoff, Kohlenstoff und Sauerstoff ist, wobei X sowohl Stickstoff als auch Kohlenstoff umfasst, wobei die Mischschicht nach der Formel (Me1aMe2b)uXv aufgebaut ist, wobei a+b=1 und v im Verhältnis zu u so gewählt ist, dass X nicht überstöchiometrisch vertreten ist, und wobei Me1 Chrom ist und Me2 Zirkon ist.

2. Zierteil nach Anspruch 1, **dadurch gekennzeichnet, dass** X ausschliesslich Stickstoff und Kohlenstoff umfasst.

3. Zierteil nach Anspruch 1 oder 2, **dadurch gekennzeichnet, dass** die Haftschicht und die Deckschicht jeweils Chrom oder jeweils Zirkon oder jeweils beide Elemente umfasst.

4. Zierteil nach einem der vorangehenden Ansprüche, **dadurch gekennzeichnet, dass** die Deckschicht Stickstoff, Kohlenstoff und/oder Sauerstoff umfasst.

5. Zierteil nach Anspruch 4, **dadurch gekennzeichnet, dass** die Deckschicht Stickstoff, Kohlenstoff und/oder Sauerstoff überstöchiometrisch umfasst.

## Claims

1. Decorative part for a motor vehicle, comprising:
- a substrate, preferably a plastic substrate,
- an electroplated layer array on the substrate
- a coloring cover layer applied to the outer surface of the electroplated layer array by means of physical vapor deposition,
**characterized in that**
the coloring cover layer is part of a PVD layer system that comprises, between the substrate and the cover layer, an adhesive layer and that comprises, between the adhesive layer and the cover layer, a mixed layer, wherein the mixed layer comprises a first metal Me1 and a second metal Me2 and elements X in the mixed layer, wherein X is one or more elements from the group consisting of nitrogen, carbon and oxygen, wherein X comprises both nitrogen and carbon, wherein the mixed layer is formed according to the formula (Me1aMe2b) uXv, wherein a+b=1, and v is selected in proportion to u in such a way that X is not represented in an overstoichiometric manner, and wherein Me1 is chromium and Me2 is zirconium.

2. Decorative part according to claim 1 **characterized in that** that X comprises exclusively nitrogen and carbon.

3. Decorative part according to claim 1 or 2 **characterized in that** the adhesive layer and the cover layer comprises each chromium or each zirconium or each both elements.

4. Decorative part according to one of the preceding claims, **characterized in that** the cover layer comprises nitrogen, carbon and/or oxygen.

5. Decorative part according to claim 4, **characterized in that** the cover layer comprises nitrogen, carbon and/or oxygen in an overstoichiometric manner.

## Revendications

1. Pièce décorative pour un véhicule automobile, comprenant :
- un substrat, de préférence un substrat en matière plastique
- une disposition de couches galvaniques sur le substrat
- une couche supérieure colorante qui est appliquée sur la surface extérieure de la disposition de couches galvaniques au moyen de dépôt physique en phase vapeur,
**caractérisée en ce que**
la couche supérieure colorante fait partie d'un système de couches PVD qui comprend une couche adhésive entre le substrat et la couche supérieure et qui comprend une couche mixte entre la couche adhésive et la couche supérieure, la couche mixte comprenant un premier métal Me1 et un second métal Me2 et des éléments X dans la couche mixte, où X est un ou plusieurs éléments du groupe constitué de l'azote, du carbone et de l'oxygène, où X comprend aussi bien de l'azote que du carbone, où la couche mixte est formée selon la formule (Me1aMe2b) uXv, où a+b=1, et v est choisi par rapport à u de telle sorte que X ne soit pas représenté de manière sur-stoechiométrique, et où Me1 est le chrome et Me2 est le zirconium.

2. Pièce décorative selon la revendication 1 **caractérisée en ce que** X comprend exclusivement de l'azote et du carbone.

3. Pièce décorative selon la revendication 1 ou 2 **caractérisée en ce que** la couche adhésive et la couche supérieure comprennent chacune du chrome ou chacune du zirconium ou chacune les deux éléments.

4. Pièce décorative selon l'une des revendications précédentes, **caractérisée en ce que** la couche supérieure comprend de l'azote, du carbone et/ou de l'oxygène.

5. Pièce décorative selon la revendication 4, **caractérisée en ce que** la couche supérieure comprend de l'azote, du carbone et/ou de l'oxygène de manière sur-stoechiométrique.
